# EUROPÄISCHE PATENTSCHRIFT

(11) **EP 1 192 291 B1**
(45) Veröffentlichungstag und Bekanntmachung des Hinweises auf die Patenterteilung: **07.05.2003**
(21) Anmeldenummer: 00954289.5
(22) Anmeldetag: 28.06.2000
(51) Int. Cl.: C23C 14/54, G01B 11/06, H01J 37/32

(54) **VORRICHTUNG ZUR ÜBERWACHUNG VON ABSICHTLICHEN ODER UNVERMEIDBAREN SCHICHTABSCHEIDUNGEN UND VERFAHREN**
DEVICE FOR MONITORING INTENDED OR UNAVOIDABLE LAYER DEPOSITS AND CORRESPONDING METHOD
DISPOSITIF DE SURVEILLANCE DE DEPOT VOULU OU INEVITABLE D'UNE COUCHE ET PROCEDE CORRESPONDANT

(30) Priorität: 28.06.1999 DE 19929615
(43) Veröffentlichungstag der Anmeldung: 03.04.2002
(73) Patentinhaber: Fraunhofer-Gesellschaft zur Förderung der angewandten Forschung e.V., 80636 München (DE); Infineon Technologies SC300 GmbH & Co. KG, 01099 Dresden (DE)
(72) Erfinder: ZIEGLER, Jürgen, D-91083 Baiersdorf (DE); WALLER, Reinhold, D-91338 Igensdorf (DE); PFITZNER, Lothar, D-91054 Erlangen (DE); SCHNEIDER, Claus, D-91088 Bubenreuth (DE); RYSSEL, Heiner, D-91058 Erlangen (DE); TEGEDER, Volker, 01474 Weissig (DE)
(74) Vertreter: Epping Hermann & Fischer
(86) Internationale Anmeldenummer: DE0002116
(87) Internationale Veröffentlichungsnummer: WO01000900

(56) Entgegenhaltungen:
- EP-A- 0 552 648
- EP-A- 0 712 942
- EP-A- 0 881 040
- DE-A- 2 750 421
- DE-A- 3 433 531

## Beschreibung

Vorrichtung zur Überwachung von absichtlichen oder unvermeidbaren Schichtabscheidungen und Verfahren

Die Erfindung betrifft eine Vorrichtung zur Überwachung von absichtlichen oder unvermeidbaren Schichtabscheidungen in einer Prozeßkammer sowie ein Verfahren zur Durchführung von Messungen mit der Vorrichtung.

Bei Bearbeitungsvorgängen, die in Prozeßkammern durchgeführt werden und bei denen Material abgetragen wird, dazu gehören beispielsweise die Verfahren reaktives Ionenätzen (reactive ion etching RIE) und chemisch unterstütztes reaktives Ionenstrahlätzen (chemical assisted ion beam etching CAIBE), kann aufgrund der verwendeten Ausgangschemikalien und der entstehenden Reaktionsprodukte auf der Innenwand des Reaktors, in dem der Bearbeitungsvorgang durchgeführt wird, unabsichtlich ein Niederschlag abgeschieden werden. Da mit zunehmender Prozeßdauer die Dicke dieses Niederschlages stetig zunimmt und ab einer bestimmten erreichten Schichtdicke eine so starke Wechselwirkung des in der Kammer durchgeführten Prozesses mit diesem Niederschlag auftritt, daß der Prozeß destabilisiert werden kann, wird deshalb in periodischen Abständen, unter Durchführung eines speziellen Reinigungsprozesses dieser unvermeidbare Niederschlag entfernt.

Während der Durchführung von Plasmaätzprozessen oder CVD (Chemical Vaper Deposition)-Abscheideprozessen werden Polymerschichten an der Innenseite der Prozeßkammer abgeschieden. Die Schichten wachsen mit zunehmender Betriebsdauer an, so daß nach dem Überschreiten einer gewissen Schichtdicke die aufgewachsene Schicht aufbricht und gegebenenfalls sogar während des Betriebs Bruchstücke abfallen können. Dadurch entstehen Verunreinigungen in der Kammer oder es werden, wenn ein Bruchstück auf die Waferoberfläche fällt, Schaltungen auf dem prozessierten Wafer unbrauchbar gemacht. Um diese unerwünschten Abscheidungen an der Innenseite der Kammer zu entfernen, ist die Prozeßkammer gelegentlich einer naßchemischen Reinigung zu unterziehen. Während der Reinigung fällt die Kammer für die weitere Produktion aus.

Die Festlegung des Zeitpunktes zur Einleitung des Reinigungsprozesses geschieht gemäß dem Stand der Technik anhand von Erfahrungswerten, die aus der Bestimmung der Qualität der prozessierten Materialien gewonnen werden. Eine aktive Überwachung des Zustandes der Kammerwand findet nur in Ausnahmefällen statt, zum Beispiel wird bei einem Sensor beziehungsweise Meßsystem zur Messung der Dicke des Niederschlages ein Meßprinzip auf der Basis der Messung von Wärmekapazität verwendet oder wird die Schichtdicke mittels Ultraschallwellenlaufzeiten bestimmt. Nachteile dieser Meßprinzipien sind zum Beispiel die Notwendigkeit zusätzlicher elektrischer Durchführungen in die Prozeßkammer zur Anbindung der Meßapparaturen an Auswertungseinheiten. Das Ultraschallwellenlaufzeitverfahren ist zudem temperaturempfindlich und wird in seiner Durchführung durch störende Reflexionen an den Aufbauten innerhalb der Prozeßkammer erschwert.

Aus den Druckschriften JP 63-153269 A, JP 01-132767 A, JP 04-176866 A, JP 05-255850 A und JP 06-49641 ist bekannt, ein Sensorelement in Form eines Monitorsubstrats im Bereich der Schichtabscheidung anzuordnen und den von einer Lichtquelle ausgehenden Transmissions- und/oder Reflexionsstrahl, das heißt die Intensitätsänderung, mittels Detektor zu erfassen und zur Einstellung von Verfahrensparametern zu nutzen. Ferner ist aus den Druckschriften JP 11-140655 A und JP 11-131211 A bekannt, mittels Photosensoren die Kammerreinigung einer Prozeßkammer zu überwachen, wobei die Intensitätsschwächung eines Lichtstrahls durch die einem Fenster in der Kammerwand aufwachsende Schicht gemessen wird.

Der Erfindung liegt die Aufgabe zugrunde, eine Vorrichtung zur Überwachung von Schichtabscheidungen in der Prozeßkammer sowie ein entsprechendes Verfahren zur Durchführung von Messungen mit der Vorrichtung anzugeben, mit denen die für die technologische und ökonomische Prozeßführung günstigsten Reinigungs-Zyklenzeiten mit möglichst geringem Aufwand ermittelt werden können.

Diese Aufgabe wird durch eine Vorrichtung zur Überwachung von Schichtabscheidungen in einer Prozeßkammer gelöst, umfassend eine Lichtquelle, ein Sensorelement, mindestens einer Lichtdetektor, wobei das Sensorelement geeignet beschaffen ist, um die Intensität des vom Detektor gemessenen Lichtstrahls durch die Dicke der auf dem Sensorelement aufwachsenden Schicht zu beeinflussen, und wobei das Sensorelement mindestens eine durchgehende Öffnung und/oder mindestens einen den Lichtstrahl wesentlich geringer absorbierenden Bereich als der restliche Teil des Sensorelements aufweist, durch die/den hindurch die Intensität des Lichts, in Abhängigkeit der durch die Dicke der aufwachsenden Schicht zuwachsenden Öffnung, gemessen wird.

Bei einem Verfahren zum Durchführen von Messungen mit der solchen Vorrichtung wird durch Vergleich der gemessenen Lichtintensität mit einer vorbestimmten Mindestintensität oder einer vorbestimmten Maximalintensität aus der Intensitätsmessung des Lichtes eine Reinigungszyklenzeit der Prozeßkammer ermittelt.

Eine Verwendung der Vorrichtung ist in Anspruch 11 angegeben.

Die bevorzugten Ausführungsformen sind Gegenstand der abhängigen Ansprüche.

Bei der Vorrichtung bzw. dem Verfahren wird zur Bestimmung der Dicke des Niederschlags die Absorption und/oder Brechung von Licht an einer mitbeschichteten Öffnung ermittelt beziehungsweise ausgewertet wird. Die Lichtquelle kann dabei prinzipiell von beliebiger Beschaffenheit sein. Bevorzugt ist entweder eine externe Lichtquelle oder die Verwendung von Plasmaleuchterscheinungen als Lichtquelle. Externe Lichtquelle bedeutet dabei nicht zwingend, daß diese außerhalb der Prozeßkammer positioniert ist, vielmehr kann sich diese auch innerhalb der Prozeßkammer befinden. Dem erfindungsgemäßen Verfahren liegt der Gedanke zugrunde, einen Gegenstand als Sensorelement in die Prozeßkammer einzubringen, an dem sich weitgehend derselbe Niederschlag wie an der Prozeßkammer niederschlägt. Die Dicke des Niederschlages, die den Zustand der Prozeßkammer und damit die für die technologische (und ökonomische) Prozeßführung günstigste Reinigungszyklenzeit festlegt, kann mit optischen Mitteln, wie zum Beispiel mittels Lichtabsorption und/oder Brechung bestimmt werden.

Das Verfahren beruht auf der Messung der Beeinflussung von Licht, zum Beispiel durch Absorption an dem Sensorelement. Das als Sensorelement bezeichnete Bauteil wird einer Stelle in die Prozeßkammer gebracht, an der mit einer in der Qualität und der Form ähnlichen Ausbildung eines Niederschlags zu rechnen ist, wie auf dem zu bearbeitenden-/zu behandelnden Gegenstand, um vorzugsweise absichtlich erzeugte Niederschläge zu überwachen. Im Speziellen, um vorzugsweise unvermeidbare Abscheidungen zu messen, wird es dort angebracht, wo mit einem in Qualität und Form ähnlichen Niederschlag zu rechnen ist wie an der Kammerwand. Das Sensorelement besteht dabei bevorzugt aus einem Material, das das zur Messung verwendete Licht vollständig absorbiert. Vorzugsweise besteht das Sensorelement aus Silizium. Am Sensorelement wird mindestens eine durchgehende Öffnung, die prinzipiell von beliebiger Form sein kann, angebracht und das zu Messung verwendete Licht wird durch diese Öffnung beobachtet und mit einem Detektor detektiert. Das Sensorelement wird also wie eine Blende verwendet. Die Öffnung, beziehungsweise die Öffnungen können auch räumlich nicht vollständig durchgehend sein. Wesentlich ist jedoch, daß diese für den Lichtstrahl nahezu vollständig durchlässig sind. Eine spezielle Ausführungsform des Sensorelements ist zum Beispiel ein geschichteter Aufbau des Sensorelements, wobei eine Schicht aus einem das verwendete Licht absorbierenden Material besteht und mindestens eine räumlich durchgehende Öffnung aufweist. Diese Schicht ist auf eine zweite Schicht, welche aus einem das verwendete Licht nicht absorbierenden Material besteht, aufgebracht. Die Größenordnung der räumlichen Dimension der Öffnung/en wird im gleichen Bereich wie die für den Kammerreinigungszeitpunkt festgelegte Schichtdicke gewählt. Das Meßprinzip beruht auf der Beobachtung des an der Öffnung absorbierten Lichtes. Die Absorption nimmt mit steigendem Zuwachsen der Öffnung zu.

Ist der Niederschlag für das verwendete Licht nur schwach absorbierend und findet das Zuwachsen der Öffnung in der Ausbildung einer linsenförmigen Struktur statt, so kann auch die zunehmende Streuung des Lichts an gekrümmten Oberflächen aufgrund von Brechung an den Grenzflächen zwischen Niederschlag und Umgebung, und aufgrund der auftretenden Lichtstreuung und Totalreflexion im Niederschlag ausgenutzt werden. Je größer die Dicke des Niederschlags ist, desto weniger Lichtintensität wird am Detektor gemessen werden können. Die Reinigungszyklenzeit oder allgemein die Beschichtungsdicke kann durch den Vergleich der gemessenen Lichtintensität mit einer vorbestimmten Mindestintensität bestimmt werden. Die Erfindung ermöglicht dadurch die aktive Überwachung des Zustandes der Kammerwand während der Beschichtung, ohne die Beschichtungsprozesse zu unterbrechen (in-situ). In analoger Vorgehensweise kann auch der mit dem Reinigungsvorgang verbundene Abtrag der Schichtdicke beobachtet werden und die zur Reinigung der Prozeßkammer nötige Zeit (Reinigungszeit) durch den Vergleich der gemessenen Lichtintensität mit einer vorbestimmten Maximalintensität bestimmt werden. Die Reinigungszyklenzeit, beziehungsweise Reinigungszeit oder allgemein die Beschichtungsdicke kann durch den Vergleich der gemessenen Lichtintensität mit einer vorbestimmten Intensität in optimaler Weise, ohne die Beschichtungsprozesse zu unterbrechen, bestimmt werden. Vorteilhaft bei der erfindungsgemäßen Vorrichtung ist neben dem geringen apparativen Aufwand auch, daß keine zusätzlichen elektrischen Durchführung in die Prozeßkammer nötig sind. Die Erfindung kann zur Überwachung sämtlicher Bearbeitungs-/Behandlungsvorgänge, bei denen eine beabsichtigte oder unbeabsichtigte Schichtabscheidung auftritt, verwendet werden.

Die vorliegende Erfindung wird ohne Beschränkung des allgemeinen Erfindungsgedankens im folgenden anhand von Ausführungsbeispielen unter Bezugnahme auf die Zeichnungen detailliert beschrieben.
- Figur 1: zeigt den prinzipiellen Aufbau einer Vorrichtung zur Durchführung des erfindungsgemäßen Verfahrens unter Verwendung einer separaten Lichtquelle 1, welche bevorzugt vor einem zweiten Fenster 6, in einer Linie mit dem Sensorelement und dem Detektor positioniert ist.
- Figur 2: zeigt den prinzipiellen Aufbau unter Ausnutzung der Plasmaleuchterscheinung 8 als Lichtquelle mit Verwendung eines zweiten Detektors 7 zur Referenzmessung.
- Figur 3: zeigt den prinzipiellen Aufbau unter Ausnutzung der Plasmaleuchterscheinung 8 als Lichtquelle mit nur einem Detektor 5 und einem Kipp-/Drehmechanismus 9 zum Herausdrehen des Sensorelements 4 aus dem Strahlengang des Lichtes zwischen der Plasmaleuchterscheinung 8 und dem Detektor 5.
- Figur 4: zeigt einen Ausschnitt aus dem Querschnitt des prinzipiellen Aufbaus des Sensorelementes mit einer durchgehenden Öffnung.
- Figur 5: zeigt einen Ausschnitt aus dem Querschnitt des prinzipiellen Aufbaus des geschichteten Sensorelementes mit einer durchgehenden Öffnung in einer ersten absorbierenden Schicht und einer zweiten nichtabsorbierenden Schicht.
- Figur 6: zeigt eine Ausführung einer Öffnung.
- Figur 7: zeigt eine Anordnung einer Meßeinrichtung an einer Wand einer Prozeßkammer.

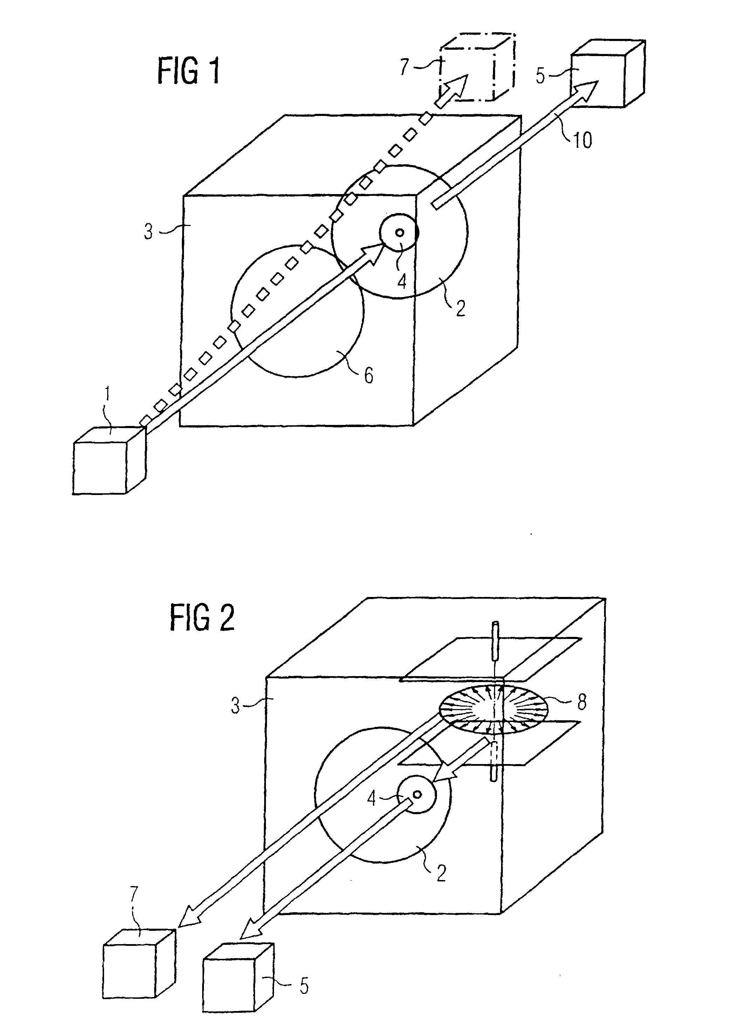

Die in Figur 1 dargestellte Vorrichtung weist eine Lichtquelle 1 auf, die einen Lichtstrahl 10 (dargestellt als Pfeil), erzeugt, der durch ein Fenster 6 in der Prozeßkammer 3 auf ein Sensorelement 4 fällt. Die Intensität des Lichts, das das Sensorelement durchdringen kann und über ein weiteres Fenster 2 die Prozeßkammer wieder verläßt, wird mit einem Detektor 5 gemessen. Die separate Lichtquelle kann sich auch innerhalb der Prozeßkammer befinden. Zum Ausgleich einer eventuellen Beschichtung der Beobachtungsfenster und/oder der separaten Lichtquelle und der damit verbundenen Abnahme der Lichtintensität oder einer Intensitätsschwankung der Lichtquelle kann ein Referenzdetektor 7 verwendet werden. Andernfalls sind die Fenster durch das Ergreifen geeigneter Maßnahmen vor einer Beschichtung im Bereich des Lichtstrahls zu schützen. Dies kann zum Beispiel durch das Zurückversetzen des Fensters in eine zylinderförmige Öffnung geschehen.

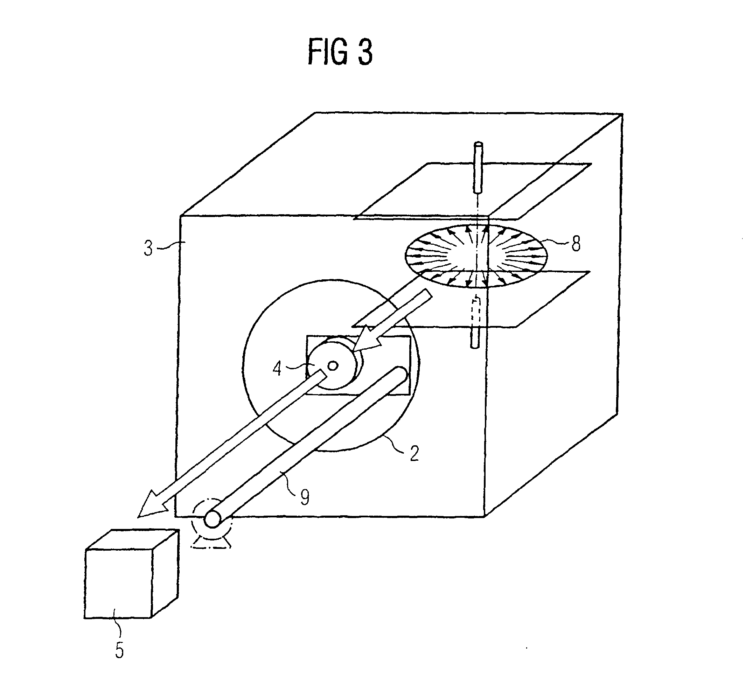

Die in Figur 2 dargestellte Vorrichtung verwendet keine separate Lichtquelle, sondern nutzt als Lichtquelle Leuchterscheinungen im Plasma selbst aus. Hier ist ein zweiter Detektor 7 nötig oder, wie in Figur 3 dargestellt, ein Kipp/Drehmechanismus 9 zum herausdrehen des Sensorelements aus dem Strahlengang zwischen der Lichtquelle und dem Detektor 5, damit die Intensität des Lichts, das ungehindert von der Quelle durch das Fenster 2 in den Detektor 5 gelangt, zur Referenz gemessen werden kann. Dieser Kipp-/Drehmechanismus kann auch in Verbindung mit einer separaten Lichtquelle eingesetzt werden. Prinzipiell ist jede Ausbildung der Lichtquelle zur Durchführung des erfindungsgemäßen Verfahrens möglich.

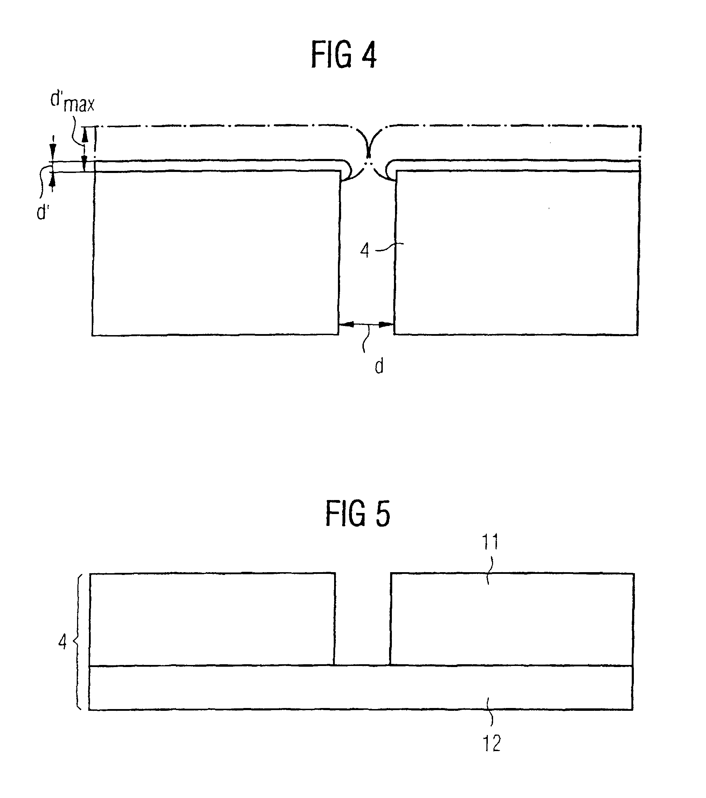

In Figur 4 wird ein Ausschnitt aus dem Querschnitt durch eine bevorzugte Ausführungsform des Sensorelements 4, welches im Strahlengang des zur Messung verwendeten Lichts positioniert wird, dargestellt. Es weist eine durchgehende Öffnung mit dem Durchmesser d in der Größenordnung der zu detektierenden maximalen Schichtdicke d'ₘₐₓ auf. Die dreidimensionale geometrische Form der Öffnung kann, zum Beispiel rund, rechteckig, schlitzförmig, konisch und so weiter ausgebildet sein. Das Sensorelement kann eine oder mehrere Öffnungen aufweisen, die unterschiedlich angeordnet sein können.

Das Verfahren basiert auf der Vorstellung, daß mit zunehmender Schichtdicke d' einer Abscheidung auch die effektive Öffnungsfläche des Sensorelements durch Zuwachsen der Öffnung verringert wird und deshalb mehr Licht absorbiert und/oder zum Beispiel durch Lichtreflexion, Lichtbrechung, Totalreflexion an gekrümmten Ober-/Grenzflächen (abgeschiedene Schicht/Kammerfüllung) gestreut wird. Als Detektor kann ein einfaches Bauelement, das auf die Intensität des einfallenden Lichts reagiert, zum Beispiel eine Photodiode, verwendet werden. Es kann aber auch eine komplizierte Vergrößerungsoptik mit nachgeschaltetem CCD-Detektor zur direkten optischen Abbildung und zum Beispiel computergestützten Auswertung der effektiven Fläche verwendet werden. Die Ausbildung des Detektorsystems ist prinzipiell beliebig, sie muß lediglich die Messung der Intensität der elektromagnetischen Strahlung ermöglichen. Auch kann das Detektorsystem außerhalb sowie innerhalb der Prozeßkammer, da dadurch die Verunreinigung der Prozeßkammer minimiert wird und eine Mitbeschichtung des Detektorsystems ausgeschlossen ist.

In Figur 5 wird ein Ausschnitt aus dem Querschnitt durch ein aus zwei Schichten aufgebautes Sensorelement 4, welches im Strahlengang des zur Messung verwendeten Lichts positioniert wird, dargestellt. Es weist eine durchgehende Öffnung in einer ersten absorbierenden Schicht 11 und eine zweite nicht absorbierende Schicht 12 ohne Öffnung auf. Die erste Schicht ist auf eine zweite Schicht, welche aus einem das verwendete Licht nicht absorbierenden Material besteht, aufgebracht. Die Größenordnung der räumlichen Dimension der Öffnung wird auch hier in der gleichen Größenordnung wie die für den Kammerreinigungszeitpunkt festgelegte Schichtdicke gewählt. Die Schichtabscheidung erfolgt bevorzugt auf der Seite des Sensorelements mit der Öffnung in der das verwendete Licht absorbierenden ersten Schicht. Die Mitbeschichtung der zweiten nichtabsorbierenden Sensorelementschicht wird dadurch und durch die zurückversetzte Position der Oberfläche der nichtabsorbierenden Schicht innerhalb der Öffnung weitestgehend vermieden.

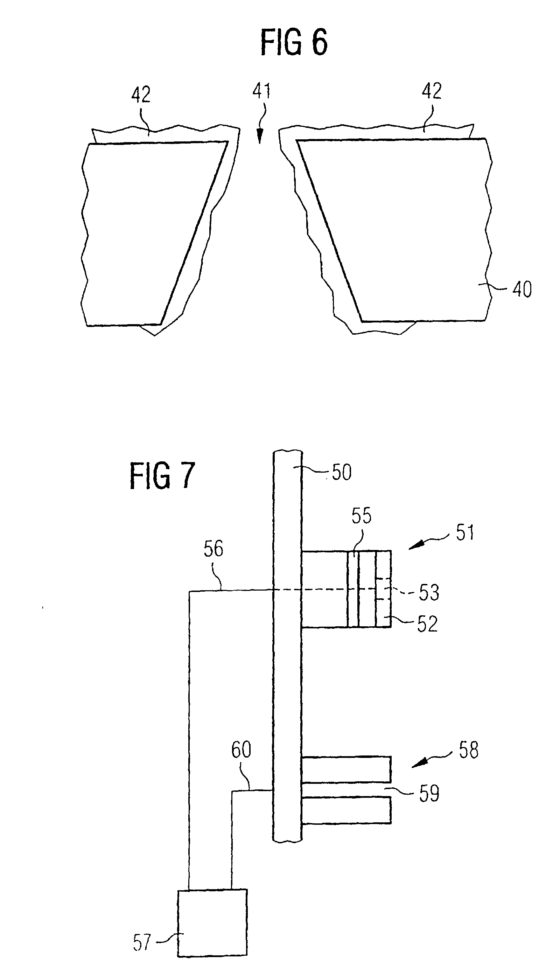

Für die Ausbildung der Öffnung sind eine Vielzahl von Varianten möglich. Bei der in Figur 6 dargestellten Öffnung besteht der lichtundurchlässige Körper 40 aus Silizium. Die Scheibe 40 weist zwei gegenüberliegende Oberflächen auf, zwischen denen die Öffnung 41 verläuft. Die Öffnung 41 weist entlang der Öffnungstiefe veränderlichen Durchmesser auf. So ist der Öffnungsdurchmesser, welcher zur Innenseite der Prozeßkammer hin gerichtet ist, kleiner als der Durchmesser, welcher vom Kammerinneren abgewandt ist, also zum Äußeren der Kammer hin weist. Durch geeignete, gegebenenfalls experimentell für den jeweiligen zu überwachenden Trockenätz- oder Abscheidungsprozeß zu ermittelnde Dimensionierung der Öffnung 41 und des lichtundurchlässigen Teils 40 des Sensors, kann eine Optimierung auf den jeweiligen zu überwachenden Prozeß erreicht werden. Insbesondere wird Form und Dicke der Abscheidung 42 im Bereich der Oberfläche der Öffnung 41 bestimmt durch die Dikke der Siliziumscheibe sowie durch das Verhältnis der Durchmesser am kammerinnenseitigen und kammeraußenseitigen Ende der Öffnung 41.

In weiterer Ausgestaltung der Erfindung ist es vorteilhaft, mehrere Sensorelemente 4 bzw. 40 nebeneinander innerhalb der Kammer anzuordnen, wobei diese Sensorelemente Öffnungen verschiedener Größe aufweisen. Das Absorptionsverhalten der verschiedenen Öffnungen wird gleichzeitig oder nacheinander überwacht. Bei fortschreitendem Wachstum der abgeschiedenen Schicht, z.B. 42, wird die kleinste der Öffnungen zuerst undurchlässig beschichtet werden, während die größeren der Öffnungen noch geringe bis gar keine Absorptionserscheinungen aufweisen. Je nach Verhältnis der absorbierenden zu den noch nicht absorbierenden Öffnungen kann der Grad an Verunreinigung innerhalb der Kammer ermittelt werden. Zweckmäßigerweise wird die durchgelassene Lichtintensität einer Öffnung mit einem absoluten oder entsprechend der Ausführung nach Figur 2 relativen Schwellwert verglichen. Der Informationsbeitrag einer Öffnung für die Messung ist dadurch digital. Insgesamt ergibt sich dann für eine Anordnung von mehreren Öffnungen verschiedenen Durchmessers eine relativ fein aufgelöste Aussage über den Verschmutzungsgrad im Inneren der Kammer.

Die Lichtsensoren, z.B. Sensor 5 in Figuren 1 bis 3, können Licht verschiedener vorbestimmter Wellenlängen oder aus verschiedenen vorbestimmten Bereichen von Wellenlängen unabhängig voneinander messen. Dadurch kann eine Optimierung der Messung im Hinblick auf das Absorptionsverhalten verschiedener Schichten getroffen werden.

In Figur 7 ist eine praktische Ausführung als Weiterbildung des Prinzips nach Figur 2 gezeigt. An der Wand 50 der Prozeßkammer sind sowohl der Sensor 51 als auch das Fenster 52 für den Referenzlichtstrahl gezeigt. Der Sensor 51 weist eine vorzugsweise aus Silizium bestehende Scheibe 52 auf, in die eine Öffnung 53 eingebracht ist. Wenn die Siliziumscheibe 52 aufgrund der in der Prozeßkammer stattfindenden Prozesse beschichtet wird, verengt sich die Öffnung 53 und deren Absorption erhöht sich. Das durch das Plasma erzeugte Licht wird dadurch beim Durchtritt durch die verengte Öffnung 53 gedämpft. Das die Öffnung 53 passierende Licht wird von einem Lichtwellenleiter 56 aufgenommen und in eine Auswerteeinrichtung 57 eingespeist. Das optische Fenster 58 empfängt das vom Plasma erzeugte Referenzlicht. Die Öffnung 59 ist so gewählt, daß etwaige Abscheidungen deren Durchlässigkeit nicht beeinflussen. Wiederum ist ein Lichtwellenleiter 60 vorgesehen, um das Referenzlicht in die Auswerteeinrichtung 57 einzuspeisen. Insbesondere wird die Prozeßkammerwand im Inneren der Öffnung 59 kaum noch durch etwaige unerwünschte Abscheidungen wegen der Tiefe der Öffnung 59 beeinflußt. In der Auswerteeinrichtung 57 befinden sich zwei lichtempfindliche Detektoren sowohl für den Meß- als auch für den Referenzlichtpfad. Diese Sensoren sind insbesondere CCD-Elemente.

Es ist besonders vorteilhaft, eine Kühleinrichtung 55 am Sensor 51 vorzusehen; alternativ kann die Einrichtung 55 auch eine Erwärmungseinrichtung sein. Kühlen/Erwärmung hängt vom jeweils gefahrenen Prozeß ab. Durch die Kühlung oder Erwärmung des Sensors 51 kann die Abscheidung an der Öffnung 53 verstärkt oder verringert, d.h. allgemein gesteuert, werden.

## Patentansprüche

1. Vorrichtung zur Überwachung von Schichtabscheidungen in einer Prozeßkammer, umfassend
- eine Lichtquelle (1, 8),
- ein Sensorelement (4),
- mindestens einen Lichtdetektor (5),
wobei das Sensorelement geeignet beschaffen ist, um die Intensität des vom Detektor gemessenen Lichtstrahls (10) durch die Dicke der auf dem Sensorelement aufwachsenden Schicht (42) zu beeinflussen,
**dadurch gekennzeichnet, daß**
das Sensorelement mindestens eine durchgehende Öffnung (41) und/oder mindestens einen den Lichtstrahl (10) wesentlich geringer absorbierenden Bereich als der restliche Teil des Sensorelements aufweist, durch die/den hindurch die Intensität des Lichts, in Abhängigkeit der durch die Dicke der aufwachsenden Schicht (42) zuwachsenden Öffnung (41), gemessen wird.

2. Vorrichtung nach Anspruch 1,
**dadurch gekennzeichnet, daß**
sich der Detektor (5) außerhalb der Prozeßkammer (3) befindet und die Intensität des Lichtes der Lichtquelle durch ein Fenster (2) in der Prozeßkammer hindurch gemessen wird.

3. Vorrichtung nach Anspruch 1 oder 2,
**dadurch gekennzeichnet, daß**
es sich bei der Lichtquelle um eine separate Lichtquelle (1) handelt, welche bevorzugt vor einem zweiten Fenster (6) in einer Linie mit dem Sensorelement und dem Detektor positioniert ist.

4. Vorrichtung nach Anspruch 1 oder 2,
**dadurch gekennzeichnet, daß**
als Lichtquelle eine Plasmaleuchterscheinung (8) in der Prozeßkammer genutzt wird.

5. Vorrichtung nach einem oder mehreren der Ansprüche 1 bis 4,
**dadurch gekennzeichnet, daß**
ein Kipp-/Drehmechanismus (9) das Herauskippen/Drehen des Sensorelements (4) aus dem Strahlengang des Lichtes zwischen Plasmaleuchterscheinung (8) oder separater Lichtquelle (1) und Detektor (5) ermöglicht.

6. Vorrichtung nach einem oder mehreren der Ansprüche 1 bis 4,
**dadurch gekennzeichnet, daß**
ein weiterer Detektor (7) zur Messung der Intensität des nicht vom Sensorelement beeinflussten Lichtes der Lichtquelle vorhanden ist.

7. Vorrichtung nach mindestens einem der Ansprüche 1 bis 6,
**dadurch gekennzeichnet, daß**
die räumliche Ausdehnung der Öffnung (42) in der gleichen Größenordnung liegt wie eine zu bestimmende maximale Schichtdicke.

8. Vorrichtung nach mindestens einem der Ansprüche 1 bis 6,
**dadurch gekennzeichnet, daß**
das Sensorelement scheibenförmig ausgebildet ist mit einer ersten und einer zweiten Oberfläche und daß die Öffnung (42) zwischen den Oberflächen verläuft, wobei der Durchmesser der Öffnung (42) variiert.

9. Vorrichtung nach einem der Ansprüche 1 bis 8,
**dadurch gekennzeichnet, daß**
das Sensorelement mit einer Kühleinrichtung oder einer Erwärmungseinrichtung (55) versehen ist.

10. Vorrichtung nach einem der Ansprüche 1 bis 9,
**dadurch gekennzeichnet, daß**
mindestens zwei Sensorelemente und zugeordnete jeweilige Lichtdetektoren vorgesehen sind, durch die ein Meßsignal erzeugbar ist, welches die Intensität des von den Sensoren durchgelassenen Lichts repräsentiert, sowie ein Auswertungsmittel, um die Meßsignale voneinander abhängig zu verarbeiten.

11. Verwendung der Vorrichtung nach einem oder mehreren der Ansprüche 1 bis 10,
**dadurch gekennzeichnet, daß**
das Aufwachsen oder das Abtragen von Schichten überwacht wird.

12. Verfahren zum Durchführen von Messungen mit der Vorrichtung nach einem oder mehreren der Ansprüche 1 bis 10,
**dadurch gekennzeichnet, daß**
durch Vergleich der gemessenen Lichtintensität mit einer vorbestimmten Mindestintensität oder einer vorbestimmten Maximalintensität aus der Intensitätsmessung des Lichtes eine Reinigungszyklenzeit der Prozeßkammer ermittelt wird.

## Claims

1. Apparatus for monitoring layer depositions in a process chamber, comprising
- a light source (1, 8),
- a sensor element (4),
- at least one light detector (5),
the sensor element being suitably configured in order to influence the intensity of the light beam (10) measured by the detector by the thickness of the layer (42) growing on the sensor element,
**characterized in that**
the sensor element has at least one continuous opening (41) and/or at least one region which absorbs the light beam (10) to a significantly lesser extent than the remaining part of the sensor element, through which opening or region the intensity of the light is measured as a function of the opening (41) grown over by the thickness of the growing layer (42).

2. Apparatus according to Claim 1,
**characterized in that**
the detector (5) is situated outside the process chamber (3) and the intensity of the light from the light source is measured through a window (2) in the process chamber.

3. Apparatus according to Claim 1 or 2,
**characterized in that**
the light source is a separate light source (1) which is preferably positioned in front of a second window (6) in a line with the sensor element and the detector.

4. Apparatus according to Claim 1 or 2,
**characterized in that**
a plasma luminous phenomenon (8) in the process chamber is utilized as the light source.

5. Apparatus according to one or more. of Claims 1 to 4,
**characterized in that**
a tilting/rotating mechanism (9) enables the sensor element (4) to be tilted/rotated out of the beam path of the light between plasma luminous phenomenon (8) or separate light source (1) and detector (5).

6. Apparatus according to one or more of Claims 1 to 4,
**characterized in that**
there is a further detector (7) for measuring the intensity of the light from the light source which is not influenced by the sensor element.

7. Apparatus according to at least one of Claims 1 to 6,
**characterized in that**
the spatial extent of the opening (42) is of the same order of magnitude as a maximum layer thickness to be determined.

8. Apparatus according to at least one of Claims 1 to 6,
**characterized in that**
the sensor element is of disc-type design with a first and a second surface, and **in that** the opening (42) extends between the surfaces, the diameter of the opening (42) varying.

9. Apparatus according to one of Claims 1 to 8,
**characterized in that**
the sensor element is provided with a cooling device or a heating device (55).

10. Apparatus according to one of Claims 1 to 9,
**characterized in that**
at least two sensor elements and assigned respective light detectors are provided, by means of which a measurement signal can be generated which represents the intensity of the light transmitted by the sensors, and also an evaluation means in order to process the measurement signals in a manner dependent on one another.

11. Use of the apparatus according to one or more of Claims 1 to 10,
**characterized in that**
the growth or the removal of layers is monitored.

12. Method for carrying out measurements with the apparatus according to one or more of Claims 1 to 10,
**characterized in that**
a cleaning cycle time of the process chamber is determined from the intensity measurement of the light by comparing the measured light intensity with a predetermined minimum intensity or a predetermined maximum intensity.

## Revendications

1. Dispositif de contrôle de dépôts de couche dans une chambre de traitement, comprenant
- une source (1, 8) de lumière,
- un élément (4) formant capteur,
- au moins un détecteur (5) de lumière,
dans lequel l'élément formant capteur est propre à influer sur l'intensité du faisceau (10) lumineux qui est mesuré par le détecteur et qui passe à travers l'épaisseur de la couche (42) en croissance sur l'élément formant capteur,
**caractérisé en ce que**
l'élément formant capteur a au moins une ouverture (41) continue et/ou au moins une partie absorbant le faisceau (10) lumineux sensiblement moins que le reste de l'élément formant capteur, ouverture ou partie dans laquelle l'intensité de la lumière est mesurée en fonction de l'ouverture (41) qui croît dans l'épaisseur de la couche (42) en croissance.

2. Dispositif suivant la revendication 1,
**caractérisé en ce que** le détecteur (5) se trouve en dehors de la chambre (3) de traitement et l'intensité de la lumière de la source lumineuse est mesurée dans une fenêtre (2) de la chambre de traitement.

3. Dispositif suivant la revendication 1 ou 2,
**caractérisé en ce qu'**il s'agit, pour la source de lumière d'une source (1) de lumière distincte qui est placée, de préférence, devant une deuxième fenêtre (10) en étant en alignement avec l'élément formant capteur et le détecteur.

4. Dispositif suivant la revendication 1 ou 2,
**caractérisé en ce qu'**il est utilisé comme source de lumière un phénomène (8) lumineux à plasma dans la chambre de traitement.

5. Dispositif suivant l'une ou plusieurs des revendications 1 à 4,
**caractérisé en ce qu'**un mécanisme (9) de basculement/rotation permet de le basculement/rotation de l'élément (4) formant capteur hors du trajet du faisceau de la lumière entre le phénomène (8) lumineux à plasma ou la source (1) de lumière distincte et le détecteur (5).

6. Dispositif suivant l'une ou plusieurs des revendications 1 à 4,
**caractérisé en ce qu'**il y a un autre détecteur (7) de mesure de l'intensité de la lumière de la source lumineuse, qui n'est pas influencée par l'élément formant capteur.

7. Dispositif suivant l'une ou plusieurs des revendications 1 à 6,
**caractérisé en ce que** l'étendue dans l'espace de l'ouverture (42) est du même ordre de grandeur qu'une épaisseur maximum de couche à déterminer.

8. Dispositif suivant l'une ou plusieurs des revendications 1 à 6,
**caractérisé en ce que** l'élément formant capteur est constitué en forme de disque ayant une première et une deuxième surface et **en ce que** l'ouverture (42) s'étend entre les surfaces dans lesquelles le diamètre de l'ouverture (42) varie.

9. Dispositif suivant l'une des revendications 1 à 8,
**caractérisé en ce que** l'élément formant capteur est muni d'un dispositif de refroidissement ou d'un dispositif (55) de réchauffement.

10. Dispositif suivant l'une des revendications 1 à 9,
**caractérisé en ce qu'**il est prévu au moins deux éléments formant capteur et des détecteurs de lumière respectivement associés par lesquels il peut être produit un signal de mesure qui représente l'intensité de la lumière ayant passé à travers les capteurs ainsi qu'un moyen d'interprétation pour traiter ces signaux de mesure indépendamment les uns des autres.

11. Utilisation du dispositif suivant l'une ou plusieurs des revendications 1 à 10,
**caractérisée en ce que** l'on contrôle la croissance ou l'enlèvement de couches.

12. Procédé pour effectuer des mesures à l'aide du dispositif suivant l'une ou plusieurs des revendications 1 à 10,
**caractérisé en ce que**, par comparaison de l'intensité lumineuse mesurée à une intensité minimum déterminée à l'avance ou à une intensité maximum déterminée à l'avance, on détermine à partir de la mesure d'intensité de lumière une durée de cycle de nettoyage de la chambre de traitement.
